# EUROPEAN PATENT SPECIFICATION

(11) **EP 0 541 872 B1**
(45) Date of publication and mention of the grant of the patent: **26.01.2000**
(21) Application number: 91310596.1
(22) Date of filing: 15.11.1991
(51) Int. Cl.: G01R 33/38, H01F 7/02

(54) **Magnetic field generating apparatus for MRI**
Apparat zur Erzeugung von Magnetfeldern für die Bildgebung mittels magnetischer Resonanz
Appareil pour la production de champs magnétiques pour l'imagerie par résonance magnétique

(43) Date of publication of application: 19.05.1993
(73) Proprietor: SUMITOMO SPECIAL METALS CO., LTD., Osaka-shi Osaka (JP); HITACHI MEDICAL CORPORATION, Tokyo (JP)
(72) Inventor: Sakurai, Hideya, Mishima-gun Osaka Prefecture (JP); Uzuki, Junji, Suita City, Osaka Prefecture (JP); Takeshima, Hirotaka, Ryugasaki City Ibaragi Prefecture (JP); Sato, Shigeru, Kitasouma-gun Ibaragi Prefecture (JP)
(74) Representative: Livsey, Gilbert Charlesworth Norris

(56) References cited:
- EP-A- 0 262 880
- WO-A-91/14948
- WO-A-91/17455
- US-A- 4 758 813
- US-A- 4 931 760

## Description

The present invention relates to an improved magnetic field generating apparatus for magnetic resonance imaging (hereinafter referred to as MRI) for medical and the like, and provides a magnetic field generating apparatus for MRI, comprising: a pair of magnetic bodies arranged to form an air gap; gradient coils within the air gap, and yokes for supporting and magnetically connecting the paired magnetic bodies; each such magnetic body being equipped with a pole piece provided with a base member of iron material disposed on its surface to confront the air gap and having a circumferential annular projection, wherein there is provided, affixed to said base member, surrounded by said circumferential annular projection, and facing said gap, an assembly of a plurality of ferrite segments, disposed to be adjacent to one another on the surface of the base member.

In such apparatus, the uniformity of the magnetic field in the air gap and the reduction of the eddy currents and residual magnetic phenomena by a gradient magnetic field coil are promoted by arranging the soft ferrite in the vicinity of the gradient magnetic field coil arranged in the gap for forming a static magnetic field.

MRI for medical diagnosis is a technique for obtaining a tomographic image of a patient's tissues by inserting a part or the whole of the patient's body into the gap of the magnetic field generating apparatus in which a strong magnetic field is formed.

In such magnetic field generating apparatus, the gap is required to have a width capable of receiving a part or the whole of the patient's body, and in order to obtain a clear tomographic image, it is desirable, in general, to form a stabilized strong uniform magnetic field having a strength of 0.05 to 2.0 T, and a variation from uniformity which is less than 1 x 10⁻⁴ T in the imaging region of the gap

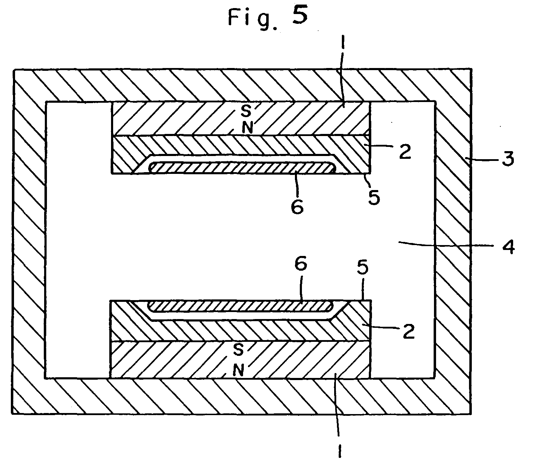

As the magnetic field generating apparatus for MRI, there are known various kinds of construction such as are shown from Fig. 5 to Fig. 7.

The construction of Fig. 5 is most commonly used, being one which uses a permanent magnet as a magnetic field generating source: a static magnetic field is generated in the gap (4) between pole pieces (2), (2), by fixing pole pieces (2), (2) to respective poles of a pair of permanent magnets (1), (1) of the Fe-B-R system, the other poles of those magnets being connected to yokes (3), (3).

A circumferential annular protrusion (5), (5) is provided integral with each of the pole pieces (2), (2) in order to improve the uniformity of the magnetic field distribution in the gap (4). Each pole piece is constituted by an integral body of a magnetic material such as an electromagnetic soft iron, pure iron, etc. in general (Japanese Patent JP-A-60-88408).

Gradient magnetic field coils (6), (6) are arranged in the vicinity of respective pole pieces (2), (2), and they comprise in general, three coil groups corresponding to the three orthogonal directions X, Y, and Z, but they are indicated diagrammatically in the figure.

In the gradient magnetic field coils (6), (6), a gradient magnetic field of a desired direction varying in time with a trapezoidal wave form can be generated by applying a pulse current.

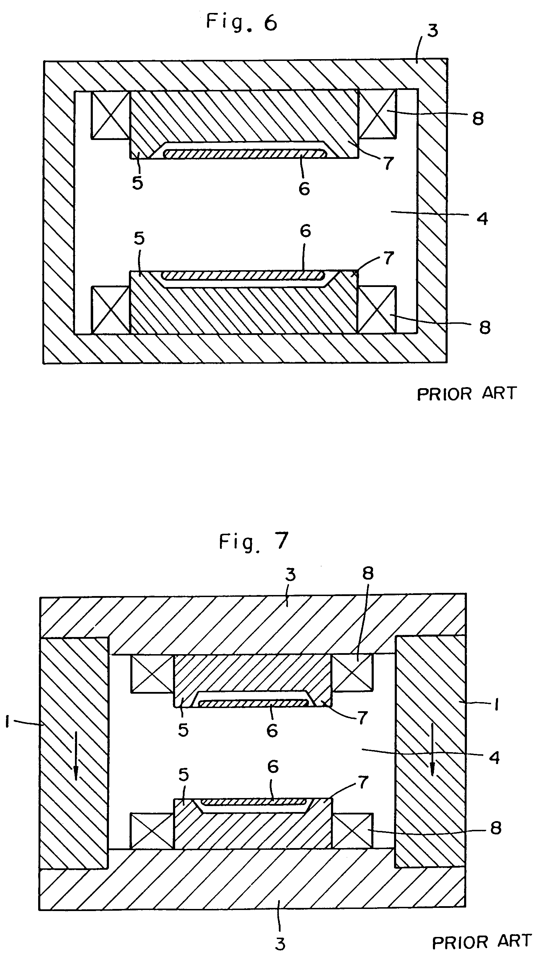

Fig. 6 shows a construction in which an electromagnet has been used as a magnetic field generating source. Exciting coils (8), (8) are arranged to surround a pair of magnetic cores (7), (7) each having an annular protrusion (5), on the surface facing the gap (4).

The exciting coils (8), (8), may be ordinary conduction coils, or super conducting coils.

In the figure, numerals (3) denote the yokes for maintaining the pair of magnetic cores (7), and (6) denotes gradient magnetic field coils.

Magnetic cores (7) for constituting the electromagnet are constituted by a monolithic plate-like body scraped out, in general, of a magnetic material such as an electromagnetic soft iron, pure iron, etc., as is the case with the pole pieces (2) of Fig. 5.

Fig. 7 shows a construction in which a permanent magnet and an electromagnet have been combined as magnetic field generating source. An electromagnet is arranged with exciting coils (8), surrounding a pair of magnetic cores (7), (7) each having a circumferential annular protrusion (5) facing the gap (4) and a pair of pillar-like Fe-B-R system permanent magnets constituting bodies (1) located between yokes (3).

In the figure, reference numerals (6) denote gradient magnetic field coils.

In any of the above-described constructions, a highly accurate and stabilized uniform magnetic field can be formed in the gap (4).

Gradient magnetic field coils (6) in any of these constructions have the same construction as that described with reference to Fig. 5, and they perform the same function.

In the construction of Fig. 5, when a pulse current is passed in the gradient magnetic field coils (6), (6), since the pole pieces (2), (2) are constituted by plate-shaped bodies as described above, and since the magnetic field changes rapidly as the current rises and falls, eddy currents are generated in the pole pieces (2), (2).

Since these eddy currents form a magnetic field which is in the reverse direction to the magnetic field formed by the gradient magnetic field coils (6), (6), much time is required for the gradient magnetic field to attain a predetermined strength.

As a means for solving the above-described problem, there has been proposed a magnetic field generating apparatus (Japanese Patent Application Laid-Open No. 61.203605) in which a flat plate-shaped laminated body comprising soft quality magnetic thin plates laminated in one direction is used as pole pieces, and is arranged and assembled in such a manner that the laminate directions thereof differ by approximately 90°, and a magnetic field generating apparatus (Japanese Patent Application Laid-Open No. 63.025907) in which the pole pieces are formed from a magnetic powder having high specific resistance.

However, even in the construction in which the above-described eddy current reduction has been devised, the pole pieces are magnetised by the magnetic field formed by the gradient magnetic field coil (GC), and there is a problem in that the uniformity in the gap is disordered by residual magnetism even after stopping the GC pulse due to magnetic hysteresis.

Even in the constructions of Fig. 6 and Fig. 7, **if** the magnetic cores (7), (7) are constituted by blocks in the same manner as in the pole pieces of Fig. 5, eddy currents are generated in the magnetic cores (7), (7) by the gradient magnetic field coils (6), (6) in the same manner as in the above-described case, and similar problems arise.

**WO-A-91/14948 (Fonar Corp.) discloses MRI apparatus in which pole pieces are each faced with an assembly of ferrite blocks in order to reduce eddy currents.**

The present invention has been proposed with the object of providing a magnetic field generating apparatus for MRI in which problems associated with eddy current and residual magnetism in the pole pieces are reduced without lowering the magnetic field uniformity in the gap.

In arriving at the present invention, in the magnetic field generating apparatus for MRI, investigation was carried out in various ways with the object of attaining a construction in which eddy currents and residual magnetism are reduced, and it was found out that these problems can be reduced by arranging soft ferrite **in a particular manner** in the vicinity of the gradient magnetic field coil arranged in the gap without lowering the magnetic field strength and the magnetic field uniformity

Accordingly, the present invention provides a magnetic field generating apparatus as defined in claim 1.

Each pole piece may be provided with a peripheral annular protrusion of various sectional forms, or the centers of the pole pieces may have a circular convex projection or trapezoidal section projection as the need arises. And magnetic field adjusting pieces of magnetic material or magnets may be arranged in desired positions on the pole pieces for the purpose of adjustment of the uniformity of magnetic field.

In the present invention, in the case when a permanent magnet is used as a magnetic field generating source, ferrite magnets, alnico system magnets, rare earth cobalt system magnets can be used, but the construction can be made remarkably small by the use of Fe-B-R system permanent magnets in which the commoner light rare earths (and in particular Nd and Pr) are chosen to be used as R, and an extremely high energy product of more than 240 KJm⁻³ [30 MGOe] can be obtained by using B and Fe as the main constituents.

Also, in the case of using an electromagnet as the magnetic field generating source, it is possible to use an ordinary conduction coil, or a super conducting coil as exciting coil arranged around the magnetic cores, rather than the conducting wires which are usually used heretofore, but it is desirable to select the exciting coil material **in** view of such factors as the magnetic field strength and economy.

Further, in the case when the electromagnet and the permanent magnet are used together, the material quality and the like are suitably selected according to similar criteria.

In the present invention, various kinds of materials can be used as the soft ferrite: these include powders such as Mn-Zn ferrite powder and Ni-Zn ferrite powder; **it is also possible to use** a monolithic construction which has been worked from a large block made of soft ferrite into a desired shape, or one which has been assembled from small blocks into a desired shape.

Also, in order to produce the above-described small block, for example, after compressing and molding the Mn-Zn (or other) ferrite powder into a required shape, the product is sintered, and, for improvement of density, it may be subjected to a hot pressing such as hot isostatic pressing. The obtained small blocks may be adhered by using an adhesive agent such as epoxy resin and the like to assemble them into a required shape

Soft ferrite materials, for example Mn-Zn system soft ferrite have high permeability and high saturation magnetic flux density which are required for making uniform means of the magnetic field, and they have sufficiently high specific resistance as an eddy current countermeasure, and the characteristic of low coercive force (several A/m) capable of preventing the residual magnetism phenomenon.

In the present invention, the magnetic flux generated by the magnet is preferably more than 0.4 T. The magnetic flux amount passing through the soft ferrite is determined by the saturated magnetic flux density (Bs) thereof, and when that value is small, the ferrite is inevitably saturated; in order to prevent this, it is necessary to make the soft ferrite body thick, and this undesirably increases the size of the magnetic field generating apparatus.

Therefore, Bs (saturated magnetic flux density) is desired to be more than 0.4 T, preferably it is more than 0.5 T and more preferably, more than 0.55 T.

Also, since residual magnetism phenomena occur when Hc (coercive force) of soft ferrite is too large, it is desirable that Hc is less than 50 A/m, and preferably it is less than 20 A/M. More preferably, Hc is less than 10 A/m.

Also, for the reduction of eddy current, it is desirable that specific resistance (ρ) is more than 10⁻⁵ Ωm and preferably, it is more than 10⁻³ Ωm.

A particularly suitable construction of the ferrite of the magnetic field generating apparatus is shown in the embodiment now to be described. For example, as shown in Figs. 5, 6 and 7, in a construction where the gap (4) is formed with the counterfacing pole pieces (2) or magnetic cores (7), it is possible to construct the whole of these pole pieces (2) or magnetic cores (7) of soft ferrite, but when the mechanical properties, magnetic efficiency, etc. of the ferrite itself are considered, a construction based on soft iron material is desirable. For example, when the construction as shown in Fig. 5, in which pole pieces (2) are arranged, is taken as the example, a base of a soft iron material is laid on a face of the magnetic body, a soft iron ring is optionally provided to form a peripheral protrusion, and soft ferrite is arranged on the above-described base, and by making the ratio of the base thickness of the soft iron material and the thickness of the soft ferrite pole to be most suitable, the uniformity of the magnetic field strength required of the pole pieces and the reduction or prevention of eddy current and residual magnetism phenomena is displayed to the maximum, and further, reinforcement of the mechanical strength of the pole pieces consisting of the ferrite can be obtained.

For the base of the above-described soft iron material, pure iron, low carbon steel, etc. are preferable as the material quality, and by adhering a circumferential circular protrusion of soft ferrite on the gap side on a base of a required thickness, uniformity of the magnetic field can be obtained.

Alternatively, it is also possible to make the circumferential circular protrusion of soft iron material, and in this case, it is desirable to divide the circular protrusion by providing slits with the object of reducing the effects of eddy currents, and further, it is desirable that the part between the base and the circular protrusion, and the part between the base and the pole pieces are electrically insulated.

In the combination of the soft ferrite of the pole pieces and the base of soft iron material, variations in conditions such as the thickness of the pole pieces and the like are restricted by the gap dimension, the required magnetic field strength in the gap, the uniformity thereof, the shapes and mechanical strength of respective parts, etc., and when the mal-effects due to the GC pulse can be reduced by the selection of the thickness of the soft ferrite only, the thinner the base thickness of the soft ferrite is, the better it will be.

However, since the thinner is the base thickness of the soft iron material, the higher becomes the passing magnetic flux density, and the magnetic hysteresis of the base itself becomes larger, and it is necessary to optimise the ratio of the thickness of the soft ferrite and the base in the pole pieces.

The preferable range of the ratio of the base thickness of the soft iron material and the thickness of the soft ferrite is base thickness/soft ferrite thickness = 0.25 to 2.

Also, in constructions, in which the magnetic cores (7) are such as shown in Figs. 6 and 7, it is preferable that the magnetic cores are formed from ferrite on bases of the soft iron material and the like in a manner similar to that of the above-described pole pieces, with the soft ferrite having the above-described various characteristics directly arranged on the pole pieces surface of the magnetic body.

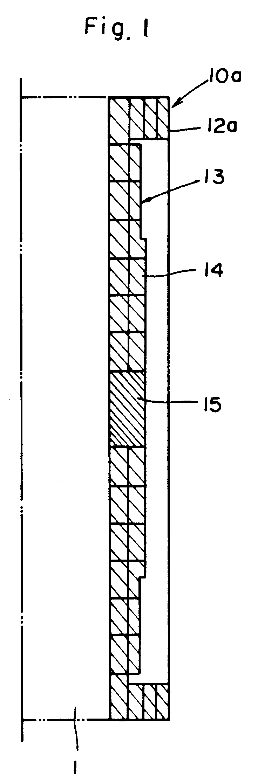

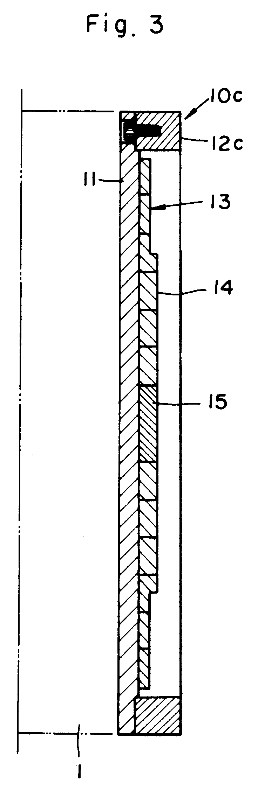

The soft ferrite according to the present invention is not necessarily arranged on the whole of the surfaces of the magnets facing the gap, and for example, as shown in the later described Figs. 1, 2, and 3 the core for arranging the gradient magnetic field coil, and the annular protrusion as shown in Fig. 3 can be constituted from another member such as soft iron, the effect of the present invention is not damaged even by adopting such a construction. Further, even in one part of the soft ferrite in the soft ferrite part (13), such arrangement is not necessarily required to be applied to the part where the influence of the eddy current is difficult to be directly received, and various kinds of constructions can be adopted in correspondence to the shape of the pole pieces, the arrangement of the gradient magnetic coil, etc.
Figs. 1 to 3 are sectional diagrams showing embodiments of the pole pieces of the magnetic field generating apparatus according to the present invention;
Fig. 4 is a top view diagram of the pole pieces shown in Fig. 3;
Fig. 5 is a sectional diagram for showing the magnetic field generating apparatus according to one prior art embodiment;
Figs. 6 and 7 are sectional diagrams for showing magnetic field generating apparatus according to other prior art embodiment s:

### (Detailed Description of the Invention)

The pole pieces (10a) shown in Fig. 1 have been constituted in such a manner that the whole of the pole pieces containing the circular protrusion provided on the gap side circumferential part is faced with soft ferrite. That is, it comprises a soft ferrite part (13), which has been made by laying over many small blocks constituted of a soft ferrite powder compressed and molded in rectangular plate shape while laminating them with an adhesive agent, and an annular protrusion (12a) which is made similarly by laminating small soft ferrite blocks. In particular, the annular protrusion (12) has the role of assembling the magnetic flux into a required gap and improving uniformity, and similarly, by forming a circular convex projection (14) of a required diameter in the central part also, the uniformity is further improved.

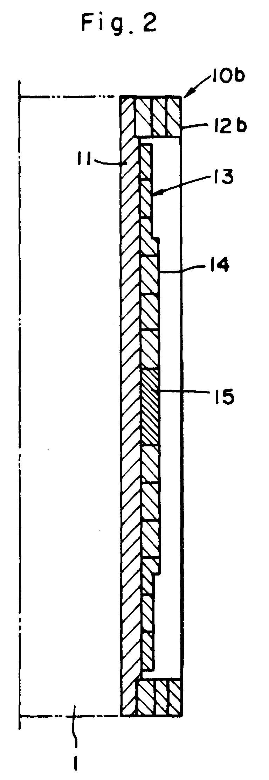

Also, at the central part of the soft ferrite (13) is provided a core (15) made of soft iron to constitute the foundation for equipping the gradient magnetic field coil. The pole pieces (10b) shown in Fig. 2 have a construction arranged with a base (11) of a circular plate shaped soft iron having a predetermined thickness between the magnet constituting body (1) and the soft ferrite part (13) in the pole pieces shown in Fig. 1, and by this base (11), the mechanical strength and magnetic efficiency of the whole pole pieces (10b) has been improved.

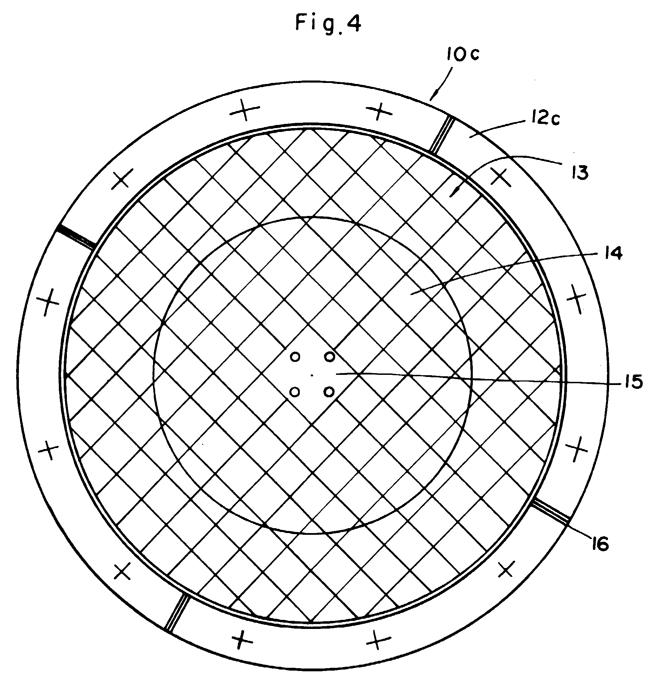

The pole pieces (10c) shown in Figs. 3 and 4 comprise bases (11) of circular plate shaped soft iron, an annular protrusion (12c) made of soft iron of rectangular section set in the circumferential part of the base (11), and a soft ferrite part (13) laid on the surface of the base (11) facing the gap by assembling many small soft ferrite blocks in a circular plate shape with an adhesive agent.

The annular protrusion (12c) made of soft iron of a rectangular section set on the circumferential part of the base (11) is made in such a manner that the height of the side of the external circumferential part of the pole pieces (10c) be higher than that of the other part to concentrate the magnetic flux in the required gap and to improve the uniformity, and an insulating material is intervened between the base (11) and the annular protrusion (12c) and stopped with bolts, and further, slits are provided by dividing the annular protrusion (12c) to provide slits (16) to get the construction for reducing the influence of the eddy current.

Although the soft ferrite part (13) has been assembled in a circular plate shape as described above, since a thicker circular part (14) of a required diameter is formed in the central part, compressed and molded soft ferrite small blocks of different thickness are used; the magnetic field uniformity can be improved by said thicker circular part.

A core (15) made of soft iron is provided in the central part 14 of the soft ferrite (13) to constitute a foundation for fitting the gradient magnetic coil.

When the pole pieces (10a), (10b), and (10c) comprising such a construction are used in the magnetic field generating apparatus for MRI shown in Fig. 6, in any of the pole piece constructions, there is the effect of making the magnetic field of the gap uniform and eddy currents due to the gradient magnetic coil are reduced, and together with that, there is the effect of reducing the residual magnetism generated by the GC pulse.

The pole piece constructions shown above can give a similar effect by adopting the magnetic cores (7) in the magnetic field generating apparatus of Fig. 6 and 7, as has been explained previously.

In magnetic field generating apparatus of the same construction as that in Fig. 5, a soft ferrite part was provided on the base consisting of soft iron of the following properties by the use of an Fe-B-R system permanent magnet having (BH) max 280 KJm⁻³ [35 MGOe] , and the counterfacing distance of a pair of pole pieces provided with an annular protrusion consisting of soft iron was set at 500 mm, and the magnetic field in the gap was measured.

As a result, as the measured value in the measuring space in the radius of 200 mm from the center of the gap, the magnetic field uniformity of 30 ppm and a magnetic field strength of 0,2 T [2 kG] was obtained.

The residual magnetism generated by the GC pulse was, in the case of the present invention, in comparison with that of the conventional one in which the pole pieces of the same dimension and shape are constituted of the bulk material of the same soft iron as that of the base, is reduced to less than 1/3.
Base
pure iron,
Hc =80 A/m,
Bs = 2.0 T,
ρ = 1 x 10⁻⁷ Ωm
soft ferrite part
Mn-Zn system ferrite
Hc = 6.0 A/m,
Bs = 0.58 T,
ρ = 0.2 Ωm

## Claims

1. A magnetic field generating apparatus for MRI, comprising: a pair of magnetic bodies (1) arranged to form an air gap (4); gradient coils (6) within the air gap (4), and yokes (3) for supporting and magnetically connecting the paired magnetic bodies (1); each such magnetic body being equipped with a pole piece (10) provided with a base member (11) of iron material disposed on its surface to confront the air gap (4) and having a circumferential annular projection (12), wherein there is provided, affixed to said base member (11), surrounded by said circumferential annular projection (12) and facing said gap (4), an assembly of a plurality of ferrite segments (13), disposed to be adjacent to one another on the surface of the base member (11), **characterised in that**
(i) the ratio t/T of the thickness (t) of the iron base member (11) to the thickness (T) of the assembly (13) of ferrite segments is in the range 0.25:1 to 2:1, and
(ii) wherein the assembly (13) of said ferrite segments is formed so as to define an outer annulus which is of lesser thickness than an inner circle thereof whereby such inner circle constitutes a circular portion (14) of said assembly of ferrite segments which stands proud of the outer circle.

2. A magnetic field generating apparatus for MRI according to Claim 1, in which the saturated magnetic flux density (Bs) is more than 0.4 T, the coercive force (Hc) is less than 50 A/m, and the specific resistance (ρ) is more than 10⁻⁵ Ωm.

3. A magnetic field generating apparatus for MRI according to Claim 2, in which the saturated magnetic flux density (Bs) of the ferrite is more than 0.5 T, the coercive force (Hc) is less than 20 A/m, and the specific resistance (ρ) is more than 10⁻³ Ωm.

4. A magnetic field generating apparatus for MRI according to Claim 3, in which the ferrite is an Mn-Zn system ferrite.

5. A magnetic field generating apparatus for MRI according to any preceding Claim, in which the magnetic bodies are constituted by permanent magnets.

6. A magnetic field generating apparatus for MRI according to any of Claims 1 to 4, in which the magnetic field generating apparatus is constituted by electromagnets or by electromagnets and permanent magnets.

7. A magnetic field generating apparatus for MRI according to any preceding Claim, in which the annular protrusion (12) is of ferrite.

8. A magnetic field generating apparatus for MRI according to any of Claims 1 to 6, in which the annular protrusion (12) is of iron.

## Patentansprüche

1. Eine, ein Magnetfeld erzeugende Vorrichtung für die MRI (Abbildung mittels magnetischer Resonanz) mit einem Paar von Magnetkörpern (1), die so angeordnet sind, daß sie einen Luftspalt (4) bilden, Gradientenspulen (6) im Luftspalt (4) und Jochen (3) zur Halterung und magnetischen Verbindung der paarweise angeordneten Magnetkörper (1), wobei jeder derartige Magnetkörper mit einem Polstück (10) ausgerüstet ist, welches mit einem Grundelement (11) aus Eisenmaterial versehen ist, das an seiner dem Luftspalt (4) gegenüberliegenden Oberfläche angeordnet ist und an seinem Umfang mit einem ringförmigen Vorsprung (12) versehen ist, wobei eine am besagten Grundelement (11) befestigte, von dem besagten, am Umfang verlaufenden ringförmigen Vorsprung (12) umgebene und dem besagten Luftspalt (4) gegenüberliegende Baueinheit vorgesehen ist, die aus einer Vielzahl von Ferritsegmenten (13) besteht, weiche aneinander angrenzen und auf der Oberfläche des Grundelements (11) angeordnet sind, dadurch gekennzeichnet, daß
(i) das Verhältnis t/T der Dicke (t) des eisernen Grundelements (11) zur Dicke (T) der Baueinheit (13) aus Ferritsegmenten im Bereich von 0,25:1 bis 2:1 liegt und
(ii) die Baueinheit (13) aus den besagten Ferritsegmenten so ausgebildet ist, daß sie einen äußeren Kreisring definiert, der eine geringere Dicke aufweist als ein innerer Kreis von ihr, wodurch dieser innere Kreis einen kreisförmigen Teil (14) der besagten Baueinheit aus Ferritsegmenten bildet, der über den äußeren Kreis hervorragt.

2. Eine ein Magnetfeld erzeugende Vorrichtung für die MRI nach Anspruch 1, bei weicher die gesättigte magnetische Flußdichte (Bs) mehr als 0,4 T, die Koerzitivkraft (Hc) weniger als 50 A/m und der spezifische Widerstand (Ωm) mehr als 10⁻⁵ ρm beträgt.

3. Eine ein Magnetfeld erzeugende Vorrichtung für die MRI nach Anspruch 2, bel weicher die gesättigte magnetische Flußdichte (Bs) für den Ferrit mehr als 0,5 T, die Koerzitivkraft (Hc) weniger als 20 A/m und der spezifische Widerstand (ρ) mehr als 10⁻³ Ωm beträgt.

4. Eine ein Magnetfeld erzeugende Vorrichtung für die MRI nach Anspruch 3, bei weicher der Ferrit ein Ferrit des Mn-Zn-Systems ist.

5. Eine ein Magnetfeld erzeugende Vorrichtung für die MRI nach irgendeinem vorgehenden Anspruch, bei weicher die Magnetkörper durch Permanentmagnete gebildet sind.

6. Eine ein Magnetfeld erzeugende Vorrichtung für die MRI nach einem der Ansprüche 1 bis 4, bei weicher die ein Magnetfeld erzeugende Vorrichtung durch Elektromagnete oder durch Elektromagnete und Permanentmagnete gebildet ist.

7. Eine ein Magnetfeld erzeugende Vorrichtung für die MRI nach irgendeinem der vorhergehenden Ansprüche, bei weicher der ringförmige Vorsprung (12) aus Ferrit besteht.

8. Eine ein Magnetfeld erzeugende Vorrichtung für die MRI nach einem der Ansprüche 1 bis 6, bei weicher der ringförmige Vorsprung (12) aus Eisen besteht.

## Revendications

1. Dispositif de génération de champ magnétique destiné à de l'imagerie par résonance magnétique (MRI) comprenant : une paire de corps magnétiques (1) disposés pour former un entrefer (4), des enroulements de gradient (6) à l'intérieur de l'entrefer (4) et des culasses (3) destinées à supporter et à relier magnétiquement les corps magnétiques appariés (1), chaque tel corps magnétique étant équipé d'une pièce polaire (10) munie d'un élément de base (11) d'un matériau de fer disposé sur sa surface afin d'être opposé A l'entrefer (4) et comportant une saillie annulaire circonférentielle (12) dans lequel est prévu, fixé audit élément de base (11), entouré par ladite saillie annulaire circonférentielle (12) et face audit entrefer (4) un ensemble constitué d'une pluralité de segments de ferrite (13), disposés pour être adjacent l'un à l'autre sur la surface de l'élément de base (11), caractérisé en ce que
(i) le rapport t/T de l'épaisseur (t) de l'élément de base de fer (11) sur l'épaisseur (T) de l'ensemble (13) des segments de ferrite est dans la plage de 0,25:1 à 2:1, et
(ii) dans lequel l'ensemble (13) desdits segments de ferrite est constitué de façon à définir un anneau extérieur qui est d'épaisseur moindre que celle d'un cercle intérieur de celui-ci, d'où il résulte qu'un tel cercle intérieur constitue une partie circulaire (14) dudit ensemble de segments de ferrite qui dépasse du cercle extérieur.

2. Dispositif de génération de champ magnétique destiné à de l'imagerie par résonance magnétique selon la revendication 1, dans lequel la densité de flux magnétique à saturation (Bs) est supérieure à 0,4 T, la force coercitive (Hc) est inférieure à 50 A/mètre, et la résistance spécifique (ρ) est supérieure à 10⁻⁵ Ωm.

3. Dispositif de génération de champ magnétique destiné à de l'imagerie par résonance magnétique selon la revendication 2, dans lequel la densité de flux magnétique à saturation (Bs) de la ferrite est supérieure à 0,5 T, la force coercitive (Hc) est inférieure à 20 A/m, et la résistance spécifique (ρ) est supérieure à 10⁻³ Ωm.

4. Dispositif de génération de champ magnétique destiné à de l'imagerie par résonance magnétique selon la revendication 3, dans lequel la ferrite est une ferrite du système Mn-Zn.

5. Dispositif de génération de champ magnétique destiné à de l'imagerie par résonance magnétique selon l'une quelconque des revendications précédentes, dans lequel les corps magnétiques sont constitués d'aimants permanents.

6. Dispositif de génération de champ magnétique destiné à de l'imagerie par résonance magnétique selon l'une quelconque des revendications 1 à 4, dans lequel le dispositif de génération de champ magnétique est constitué d'électro-aimants ou d'électro-aimants et d'aimants permanents.

7. Dispositif de génération de champ magnétique destiné à de l'imagerie par résonance magnétique selon l'une quelconque des revendications précédentes, dans lequel la saillie annulaire (12) est faite de ferrite.

8. Dispositif de génération de champ magnétique destiné à de l'imagerie par résonance magnétique selon l'une quelconque des revendications 1 à 6, dans lequel la saillie annulaire (12) est faite de fer.
